# EUROPEAN PATENT APPLICATION

(11) **EP 4 556 920 A1**
(43) Date of publication of application: **21.05.2025**
(21) Application number: 23860848.3
(22) Date of filing: 29.08.2023
(51) Int. Cl.: G01R 31/367, G01R 31/392, G06N 3/08

(54) **BATTERY STATE PREDICTION DEVICE AND OPERATING METHOD THEREFOR**

(30) Priority: 30.08.2022 KR 20220109524
(71) Applicant: LG Energy Solution, Ltd., Seoul 07335 (KR)
(72) Inventor: CHUNG, Won Seok, Daejeon 34122 (KR); JO, Vin Na, Daejeon 34122 (KR); PARK, Jun Cheol, Daejeon 34122 (KR)
(74) Representative: Plasseraud IP
(86) International application number: PCT/KR2023/012809
(87) International publication number: WO 2024/049172

(57) **Abstract**

A battery state prediction apparatus according to an embodiment disclosed herein includes a data managing unit configured to extract first battery data obtained for a predetermined time after completion of charging of a battery and second battery data obtained for the predetermined time after completion of discharging of the battery and a controller configured to obtain first state data for predicting a state of the battery by applying the first battery data to a first deep learning model, obtain second state data for predicting the state of the battery by applying the second battery data to a second deep learning model, and predict the state of the battery based on the first state data and the second state data.

## Description

### [TECHNICAL FIELD]

### CROSS-REFERENCE TO RELATED APPLICATION

This application claims priority to and the benefit of Korean Patent Application No. 10-2022-0109524 filed in the Korean Intellectual Property Office on August 30, 2022, the entire content of which is incorporated herein by reference.

### TECHNICAL FIELD

Embodiments disclosed herein relate to a battery state prediction apparatus and an operating method thereof.

### [BACKGROUND ART]

An electric vehicle is supplied with electricity from outside to charge a battery, and then a motor is driven by a voltage charged in the battery to obtain power. The battery of the electric vehicle may have heat generated therein by chemical reaction occurring in a process of charging and discharging electricity, and the heat may impair performance and lifetime of the battery. Thus, a battery management system (BMS) that monitors temperature, voltage, and current of the battery is driven to predict a lifetime (a state of health (SoH)) of the battery.

The battery management system may analyze the state of the battery by training large-volume battery data in an artificial intelligence model that analyzes the state of the battery. However, the battery management system undergoes efficiency degradation in a process of managing and analyzing the large-volume battery data, reducing performance and speed of the artificial intelligence model and causing an error. Accordingly, there is a need to analyze the state of the battery by establishing a suitable train data set to be input into the artificial intelligence model.

### [DISCLOSURE]

### [TECHNICAL PROBLEM]

Embodiments disclosed herein aim to provide a battery state prediction apparatus and an operating method thereof in which a part of battery data is extracted as train data to train an artificial intelligence model that analyzes a battery state, thereby improving performance of the artificial intelligence model.

Technical problems of the embodiments disclosed herein are not limited to the above-described technical problems, and other unmentioned technical problems would be clearly understood by one of ordinary skill in the art from the following description.

### [TECHNICAL SOLUTION]

A battery state prediction apparatus according to an embodiment disclosed herein includes a data managing unit configured to extract first battery data obtained for a predetermined time after completion of charging of a battery and second battery data obtained for the predetermined time after completion of discharging of the battery and a controller configured to obtain first state data for predicting a state of the battery by applying the first battery data to a first deep learning model, obtain second state data for predicting the state of the battery by applying the second battery data to a second deep learning model, and predict the state of the battery based on the first state data and the second state data.

According to an embodiment, the controller may be further configured to generate third state data by combining the first state data with the second state data and predict the state of the battery based on the third state data.

According to an embodiment, the controller may be further configured to extract a feature of the first battery data by applying the first battery data to a first convolutional neural network (CNN) model and extract a feature of the second battery data by applying the second battery data to a second CNN model.

According to an embodiment, the controller may be further configured to generate a third value based on a weighted sum of a first value, obtained by converting the feature of the first battery data into an embedding vector, and a second value, obtained by converting the feature of the second battery data into an embedding vector, and predict the state of the battery based on the third value.

According to an embodiment, the first battery data and the second battery data may include a voltage, a current, and a temperature of the battery, measured accumulatively, and the first state data, the second state data, and the third state data may include a state of health (SoH) of the battery, calculated based on the first battery data and the second battery data.

An operating method of a battery state prediction apparatus according to an embodiment disclosed herein includes extracting, from battery data, first battery data obtained for a predetermined time after completion of charging of a battery, extracting, from the battery data, second battery data obtained for the predetermined time after completion of discharging of the battery, obtaining first state data for predicting a state of the battery by applying the first battery data to a first deep learning model, obtaining second state data for predicting the state of the battery by applying the second battery data to a second deep learning model, and predicting the state of the battery based on the first state data and the second state data.

According to an embodiment, the predicting of the state of the battery based on the first state data and the second state data may include generating third state data by combining the first state data with the second state data and predicting the state of the battery based on the third state data.

According to an embodiment, the obtaining of the first state data for predicting a state of the battery by applying the first battery data to the first deep learning model, may include extracting a feature of the first battery data by applying the first battery data to a first convolutional neural network (CNN) model, and the obtaining of the second state data for predicting the state of the battery by applying the second battery data to the second deep learning model, may include extracting a feature of the second battery data by applying the second battery data to a second CNN model.

According to an embodiment, the predicting of the state of the battery based on the first state data and the second state data may include generating a third value based on a weighted sum of a first value, obtained by converting the feature of the first battery data into an embedding vector, and a second value, obtained by converting the feature of the second battery data into an embedding vector, and predicting the state of the battery based on the third value.

According to an embodiment, the predicting of the state of the battery based on the first state data and the second state data may include predicting a state of health (SoH) of the battery.

### [DESCRIPTION OF DRAWINGS]

FIG. 1 illustrates a battery pack according to an embodiment disclosed herein.
FIG. 2 is a view for generally describing a battery state prediction apparatus according to an embodiment disclosed herein.
FIG. 3 is a block diagram showing a configuration of a battery state prediction apparatus, according to an embodiment disclosed herein.
FIG. 4A is a graph showing a voltage change of battery data according to an embodiment disclosed herein.
FIG. 4B is a graph showing a voltage change of first battery data according to an embodiment disclosed herein.
FIG. 4C is a graph showing a voltage change of second battery data according to an embodiment disclosed herein.
FIG. 5 is a flowchart of an operating method of a battery state prediction apparatus according to an embodiment disclosed herein.
FIG. 6 is a block diagram showing a hardware configuration of a computing system for implementing a battery state prediction apparatus according to an embodiment disclosed herein.

### [MODE FOR INVENTION]

Hereinafter, some embodiments disclosed in this document will be described in detail with reference to the exemplary drawings. In adding reference numerals to components of each drawing, it should be noted that the same components are given the same reference numerals even though they are indicated in different drawings. In addition, in describing the embodiments disclosed in this document, when it is determined that a detailed description of a related known configuration or function interferes with the understanding of an embodiment disclosed in this document, the detailed description thereof will be omitted.

To describe a component of an embodiment disclosed herein, terms such as first, second, A, B, (a), (b), etc., may be used. These terms are used merely for distinguishing one component from another component and do not limit the component to the essence, sequence, order, etc., of the component. The terms used herein, including technical and scientific terms, have the same meanings as terms that are generally understood by those skilled in the art, as long as the terms are not differently defined. Generally, the terms defined in a generally used dictionary should be interpreted as having the same meanings as the contextual meanings of the relevant technology and should not be interpreted as having ideal or exaggerated meanings unless they are clearly defined in the present document.

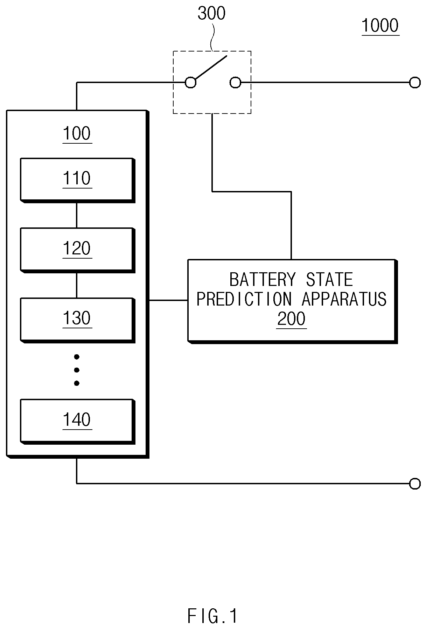

FIG. 1 illustrates a battery pack according to an embodiment disclosed herein.

Referring to FIG. 1, a battery pack 1000 according to an embodiment disclosed herein may include a battery module 100, a battery state prediction apparatus 200, and a relay 300.

The battery module 100 may include a plurality of battery cells 110, 120, 130, and 140. Although the plurality of battery cells are illustrated as four in FIG. 1, the present disclosure is not limited thereto, and the battery module 100 may include n battery cells (n is a natural number equal to or greater than 2).

The battery module 100 may supply power to a target device (not shown). To this end, the battery module 100 may be electrically connected to the target device. Herein, the target device may include an electrical, electronic, or mechanical device that operates by receiving power from the battery pack 1000 including the plurality of battery cells 110, 120, 130, and 140, and the target device may be, for example, an electric vehicle (EV) or an energy storage system (ESS), but is not limited thereto.

The plurality of battery cells 110, 120, 130, and 140, each of which is a basic unit of a battery available by charging and discharging electrical energy, may be a lithium ion (Li-ion) battery, an Li-ion polymer battery, a nickel-cadmium (Ni-Cd) battery, a nickel hydrogen (Ni-MH) battery, etc., and are not limited thereto. Meanwhile, although one battery module 100 is illustrated in FIG. 1, the battery module 100 may be configured in plural according to an embodiment.

The battery state prediction apparatus 200 may predict states of battery cells, which include lifetimes (states of health (SoH)) of the plurality of battery cells 110, 120, 130, and 140, based on temperature, current, and voltage data of the plurality of battery cells 110, 120, 130, and 140. The battery state prediction apparatus 200 may predict the states of the plurality of battery cells 110, 120, 130, and 140 for each of temperature, current, and voltage of a battery based on battery data of the plurality of battery cells 110, 120, 130, and 140.

According to an embodiment, the battery state prediction apparatus 200 may be implemented in the form of a battery management system (BMS). Moreover, according to an embodiment, the battery state prediction apparatus 200 may be mounted on a battery management system.

Herein, the battery management system may manage and/or control a state and/or an operation of the battery module 100. For example, the battery management system may manage and/or control the states and/or operations of the plurality of battery cells 110, 120, 130, and 140 included in the battery module 100. The battery management system may manage charge and/or discharge of the battery module 100.

In addition, the battery management system may monitor voltage, current, temperature, etc., of the battery module 100 and/or each of the plurality of battery cells 110, 120, 130, and 140 included in the battery module 100. A sensor or various measurement modules for monitoring performed by the battery management system, which are not shown, may be additionally installed in the battery module 100, a charging/discharging path, any position of the battery module 100, etc. The battery management system may calculate a parameter indicating a state of the battery module 100, e.g., a state of charge (SoC), a SoH, etc., based on a measurement value such as monitored voltage, current, temperature, etc.

The battery management system may control an operation of the relay 300. For example, the battery management system may short-circuit the relay 300 to supply power to the target device. The battery management system may short-circuit the relay 300 when a charging device is connected to the battery pack 1000.

The battery management system may calculate a cell balancing time of each of the plurality of battery cells 110, 120, 130, and 140. Herein, the cell balancing time may be defined as a time required for balancing of the battery cell. For example, the battery management system may calculate a cell balancing time based on an SoC, a battery capacity, and a balancing efficiency of each of the plurality of battery cells 110, 120, 130, and 140.

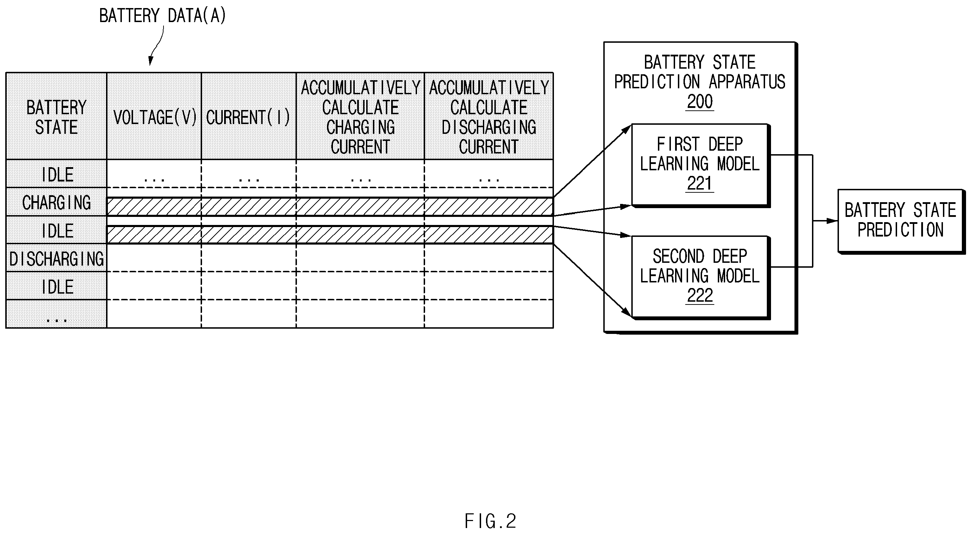

FIG. 2 is a view for generally describing a battery state prediction apparatus according to an embodiment disclosed herein.

Referring to FIG. 2, the battery state prediction apparatus 200 may extract a part of battery data A
The battery state prediction apparatus 200 may obtain the battery data A of the plurality of battery cells 110, 120, 130, and 140. To identify deterioration performance, i.e., SoH, of the plurality of battery cells 110, 120, 130, and 140, the battery management system may obtain the battery data A including a measurement value of a battery from a voltage value at which the SoC of the battery is 0% up to a voltage value at which the SoC of the battery is 100%. Thus, the battery state prediction apparatus 200 may obtain the battery data A including voltages, currents, and temperatures of the plurality of battery cells 110, 120, 130, and 140 accumulatively measured during a charge/discharge period.

The battery state prediction apparatus 200 may establish a train data set to be used for a deep learning model of the battery state prediction apparatus 200 based on the battery data A. Deep learning, which is one of types of machine learning algorithms, may refer to a technique that connects artificial neural networks in the form of numerous layers. Machine learning may refer to a technique for training a computer to predict a certain result. Generally, a result of using machine learning includes a process of preparing train data for training a machine and training the computer in a manner suitable for a problem, a process of validating a model with test data, and a process of predicting a result with a model having passed the verification.

For machine learning, it is important that train data well represents a feature to be generalized through machine learning, and thus the train data is generated using train data limitedly selected according to certain criteria For a low relation between the feature to be generalized through machine learning and a feature of train data, a sampling noise may occur, and a pattern having a machine problem analysis model embedded therein is difficult to find, increasing an error of the model separately from the accuracy of the machine problem analysis model and thus degrading the reliability of the model. Thus, a machine learning technique requires investment of time in evaluating train data and processing data to select a train data set.

The battery state prediction apparatus 200 may extract a part of the battery data A and generate a train data set to train a first deep learning model 221 and a second deep learning model 222. Herein, the first deep learning model 221 and the second deep learning model 222 may refer to learning models capable of predicting a state of the battery including a lifetime (SoH) of the battery based on input battery data.

That is, the battery state prediction apparatus 200 may generate a train data set for machine learning of the first deep learning model 221 and the second deep learning model 222 to reduce an error of machine learning of the first deep learning model 221 and the second deep learning model 222 and improve the reliability of the machine learning. The battery state prediction apparatus 200 may input the train data set to the first deep learning model 221 and the second deep learning model 222 to predict the states of the plurality of battery cells 110, 120, 130, and 140.

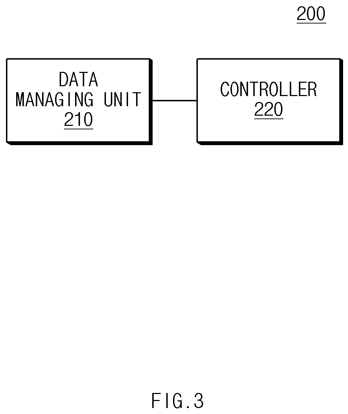

FIG. 3 is a block diagram showing a configuration of a battery state prediction apparatus, according to an embodiment disclosed herein.

Hereinbelow, with reference to FIG. 3, a configuration and an operation of the battery state prediction apparatus 200 will be described in detail.

First, referring to FIG. 3, the battery state prediction apparatus 200 may include a data managing unit 210 and a controller 220.

The data managing unit 210 may collect the battery data A. For example, the battery data A may be defined as a value that records a change in the amount of electricity from discharge states of the plurality of battery cells 110, 120, 130, and 140 to full charge states thereof or from the full charge states to the discharge states.

The data managing unit 210 may extract first battery data A1 obtained for a predetermined time after completion of charging of the battery and second battery data A2 obtained for the predetermined time after completion of discharging of the battery. Herein, the first battery data A1 and the second battery data A2 may include voltage, current, and temperature of the battery, measured accumulatively.

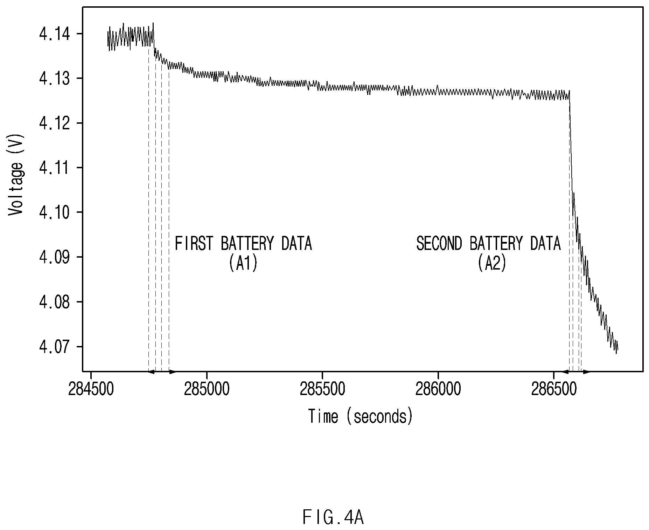

FIG. 4A is a graph showing a voltage change of battery data according to an embodiment disclosed herein.

Referring to FIG. 4A, a period in which a voltage of the battery sharply changes may be extracted from the battery data A. The data managing unit 210 may set, as the first battery data A1, a period in which a voltage of the battery sharply changes in an idle period after charging of the battery in the battery data A. The data managing unit 210 may set, as the second battery data A2, a period in which a voltage of the battery sharply changes in a discharging period after idling of the battery in the battery data A.

A deep learning model has been conventionally trained using behaviors of the voltage or current of the whole battery data A, but when the entire battery data A is used as train data, a very long analysis time is required. The data managing unit 210 may extract data required for lifetime prediction of the battery in which the voltage or current of the battery sharply changes in the battery data A as the first battery data A1 and the second battery data A2.

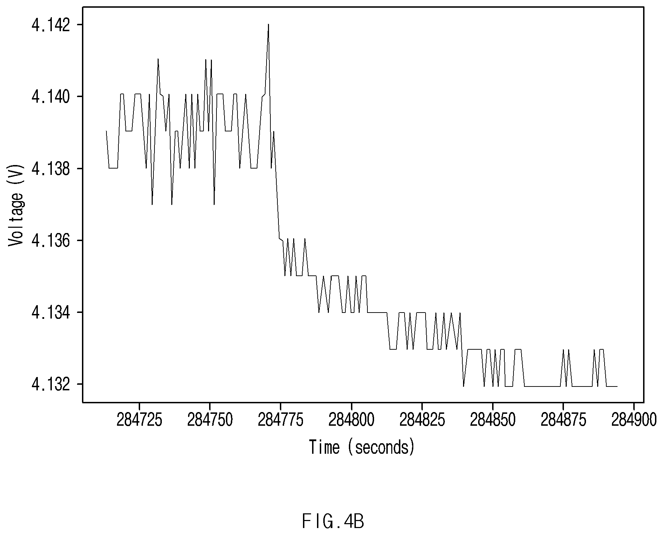

FIG. 4B is a graph showing a voltage change of first battery data according to an embodiment disclosed herein.

The first battery data A1 shown in FIG. 4B may include voltage change information of the battery in the idle period after charging of the battery. When a charging/discharging cycle is repeated, a capacity of the battery may constantly deteriorate as the resistance of the battery increases. Thus, the voltage or the open circuit may constantly decrease even after charging of the battery. The data managing unit 210 may extract the first battery data A1 corresponding to a voltage change of the idle period after charging of the battery to use the same for training the deep learning model.

For example, the first battery data A1 may include data of the last 1 second of the charging period of the battery and data of 60 seconds of the idle period immediately after charging of the battery. That is, the first battery data A1 may include the battery data A corresponding to a period of a total of 61 seconds.

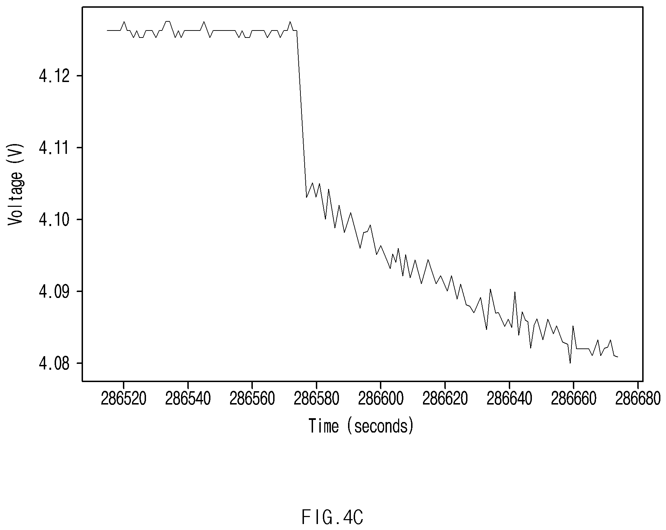

FIG. 4C is a graph showing a voltage change of second battery data according to an embodiment disclosed herein.

The second battery data A2 shown in FIG. 4C may include voltage change information of the battery at the time of entering a discharging period after idling of the battery. The battery may be affected by an ohmic resistance generated due to an internal resistance of the battery as current is applied to the battery at the start of discharging after idling. Thus, the second battery data A2 including the voltage change information of the battery of the discharging period after idling of the battery may include a voltage drop phenomenon (IR Drop) occurring due to the internal resistance of the battery. Herein, the voltage drop phenomenon may refer to a potential difference between two points in a conducting phase while the current flows. The data managing unit 210 may extract the second battery data A2 corresponding to a voltage change of the discharging period after idling of the battery to use the same for training the deep learning model.

For example, the second battery data A2 may include the last 1 second of the idling period after charging of the battery and data of 40 seconds of the discharging period immediately after idling of the battery. That is, the second battery data A2 may include the battery data A corresponding to a period of a total of 41 seconds.

Referring back to FIG. 3, the data managing unit 110 may collect the first battery data A1 and the second battery data A2 as a train data set to be input to the deep learning model. The data managing unit 210 may manage the first battery data A1 and the second battery data A2 separately as respective time-series data. Herein, the time-series data may refer to data arranged at specific time intervals over time.

The controller 220 may predict a state of the battery by applying the first battery data A1 and the second battery data A2 including temperature, current, and voltage changes of the plurality of battery cells 110, 120, 130, and 140 to a deep learning model of a time-series analysis structure.

The controller 220 may obtain first state data for predicting the state of the battery, by applying the first battery data A1 to the first deep learning model 221. The controller 220 may obtain second state data for predicting the state of the battery, by applying the second battery data A2 to the second deep learning model 222. That is, the controller 220 may obtain separate output data by inputting the first battery data A1 and the second battery data A2 to separate deep learning models.

Herein, the first state data and the second state data may include lifetime (SoH) data of the battery, calculated using the first battery data A1 as train data of the first deep learning model 221, and SoH data of the battery, calculated using the second battery data A2 as train data of the second deep learning model 222.

According to an embodiment, the first deep learning model 221 and the second deep learning model 222 may include, for example, a one-dimensional (1D) convolutional neural network (CNN) model. Herein, the CNN model may mainly extract a feature of matrix data or image data. Herein, 1D may mean that a kernel for convolution and a sequence of data to be applied have an 1D shape. The 1D CNN may analyze a feature of time-series data or a text.

According to an embodiment, the controller 220 may extract a feature of the first battery data A1 by applying the first battery data A1 to a first CNN model. The controller 220 may also extract a feature of the second battery data A2 by applying the second battery data A2 to a second CNN model.

The controller 220 may predict the state of the battery based on the first state data and the second state data. More specifically, the controller 220 may generate third state data by combining the first state data with the second state data. The controller 220 may predict the state of the battery based on the third state data. Herein, the third state data may include lifetime data of the battery.

According to an embodiment, the controller 220 may generate a third value by combining a first value obtained by converting the feature of the first battery data A1 into an embedding vector with a second value obtained by converting the feature of the second battery data A2 into an embedding vector. Herein, embedding may be defined as a process of converting a natural language used by human into an array of numbers that may be understood by machines. More specifically, the controller 220 may combine the first value with the second value by inputting them into a sequential function (concatenate).

The controller 220 may generate the third value by inputting the data, generated by combining the first value with the second value, into a single-layer perceptron model. Herein, the single-layer perceptron model may receive a plurality of signals as an input and output one signal. The single-layer perceptron model may generate an output signal based on a weighted sum that assigns a weight value to each of the plurality of input signals and sums values obtained by multiplying unique weight values to the respective signals. Herein, the weighted sum may be defined as an average value obtained by reflecting a weight value corresponding to an importance or influence of a data value when an average of data is obtained.

That is, the controller 220 may generate the third value based on a weighted sum of the first value and the second value by inputting the first value and the second value into the single-layer perceptron model. The third value may be generated by multiplying the first value and the second value by the weight values and summing the multiplication results. Herein, the weight values of the first value and the second value may be determined to maximize accuracy through a test using a test data set. Thus, the controller 220 may obtain the third value, which is prediction data of the state of the battery. Herein, the third value may include lifetime data of the battery.

Embodiments disclosed herein aim to provide a battery state prediction apparatus and an operating method thereof in which a part of battery data is extracted as train data to train an artificial intelligence model that analyzes a battery state, thereby improving performance of the artificial intelligence model.

As described above, the battery state prediction apparatus according to an embodiment disclosed herein may extract a part of battery data and then train a plurality of deep learning models with the same, thereby improving the accuracy of the deep learning model.

Moreover, the battery state prediction apparatus may simplify and lightweight train data, thereby reducing a computing time of a deep learning model for predicting the state of the battery in real time and reducing a time required for collecting and managing the train data.

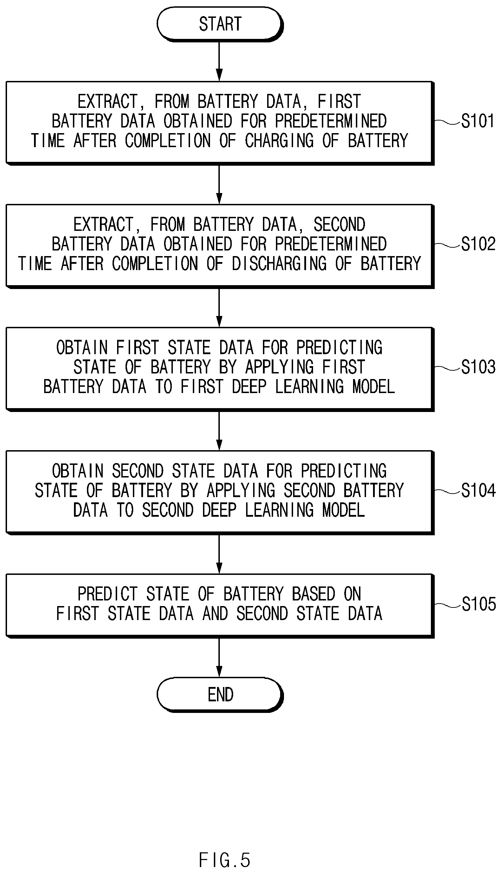

FIG. 5 is a flowchart of an operating method of a battery state prediction apparatus according to an embodiment disclosed herein.

The battery state prediction apparatus 200 may be substantially the same as the battery state prediction apparatus 200 described with reference to FIGS. 1 to 4C, and thus will be briefly described to avoid redundant description.

Referring to FIG. 5, an operating method of a battery state prediction apparatus may include operation S101 of extracting, from the battery data A, the first battery data A1 obtained during a predetermined time after completion of charging of the battery, operation S102 of extracting, from the battery data, the second battery data A2 obtained during a predetermined time after completion of discharging of the battery, operation S103 of obtaining the first state data for predicting the state of the battery by applying the first battery data A1 to the first deep learning model 221, operation S104 of obtaining the second state data for predicting the state of the battery by applying the second battery data A2 to the second deep learning model 222, and operation S105 of predicting the state of the battery based on the first state data and the second state data.

Hereinbelow, operations S101 through S105 will be described in detail.

In operation S101, the data managing unit 210 may collect the battery data A of the plurality of battery cells 110, 120, 130, and 140. For example, the battery data A may be defined as a value that records a change in the amount of electricity from discharge states of the plurality of battery cells 110, 120, 130, and 140 to full charge states thereof or from the full charge states to the discharge states. Thus, the data managing unit 210 may obtain the battery data A including voltages, currents, and temperatures of the plurality of battery cells 110, 120, 130, and 140 accumulatively measured during a charge/discharge period.

In operation S101, the data managing unit 210 may extract, from the battery data A, the first battery data A1 obtained during a predetermined time after completion of charging of the battery. In operation S101, the data managing unit 210 may extract the first battery data A1 corresponding to a voltage change of the idle period after charging of the battery to use the same for training the deep learning model.

Herein, the first battery data A1 may include voltage, current, and temperature of the battery, measured accumulatively. For example, the first battery data A1 may include data of the last 1 second of the charging period of the battery and data of 60 seconds of the idle period immediately after charging of the battery. That is, the first battery data A1 may include the battery data A corresponding to a period of a total of 61 seconds.

In operation S102, the data managing unit 210 may extract, from the battery data A, the second battery data A2 obtained during a predetermined time after completion of discharging of the battery. In operation S102, the data managing unit 210 may extract the second battery data A2 corresponding to a voltage change of the discharging period after idling of the battery to use the same for training the deep learning model.

Herein, the second battery data A2 may include voltage, current, and temperature of the battery, measured accumulatively. For example, the second battery data A2 may include data of the last 1 second of the idling period after charging of the battery and data of 40 seconds of the discharging period immediately after idling of the battery. That is, the second battery data A2 may include the battery data A corresponding to a period of a total of 41 seconds.

In operation S103, the controller 220 may obtain first state data for predicting the state of the battery, by applying the first battery data A1 to the first deep learning model 221.

In operation S103, more specifically, the controller 220 may predict a state of the battery by applying the first battery data A1 including temperature, current, and voltage changes of the plurality of battery cells 110, 120, 130, and 140 to a deep learning model of a time-series analysis structure.

Herein, the first state data may include lifetime (SoH) data of the battery, calculated using the first battery data A1 as train data of the first deep learning model 221. Herein, the first deep learning model 221 may include, for example, an 1D CNN model. The CNN model may mainly extract a feature of matrix data or image data. Herein, 1D may mean that a kernel for convolution and a sequence of data to be applied have an 1D shape. The 1D CNN may analyze a feature of time-series data or a text.

In operation S103, the controller 220 may also extract a feature of the first battery data A1 by applying the first battery data A1 to the first CNN model.

In operation S104, the controller 220 may obtain second state data for predicting the state of the battery, by applying the second battery data A2 to the second deep learning model 222.

In operation S104, more specifically, the controller 220 may predict the state of the battery by applying the second battery data A2 including temperature, current, and voltage changes of the plurality of battery cells 110, 120, 130, and 140 to a deep learning model of a time-series analysis structure. Herein, the second state data may include lifetime (SoH) data of the battery, calculated using the second battery data A2 as train data of the second deep learning model 222. Herein, the second deep learning model 222 may include, for example, the 1D CNN model.

In operation S104, the controller 220 may extract a feature of the second battery data A2 by applying the second battery data A2 to the second CNN model.

In operation S105, the controller 220 may predict the state of the battery based on the first state data and the second state data. In operation S105, the controller 220 may generate third state data by combining the first state data with the second state data. In operation S105, the controller 220 may predict the state of the battery based on the third state data. Herein, the third state data may include lifetime data of the battery.

In operation S105, according to an embodiment, the controller 220 may generate the third value by combining the first value obtained by converting the feature of the first battery data A1 into an embedding vector with the second value obtained by converting the feature of the second battery data A2 into an embedding vector. Herein, embedding may be defined as a process of converting a natural language used by human into an array of numbers that may be understood by machines.

In operation S105, more specifically, the controller 220 may combine the first value with the second value by inputting them into a sequential function (concatenate). In operation S105, the controller 220 may generate the third value by inputting the data, generated by combining the first value with the second value, into a single-layer perceptron model. Herein, the single-layer perceptron model may receive a plurality of signals as an input and output one signal. The single-layer perceptron model may generate an output signal based on a weighted sum that assigns a weight value to each of the plurality of input signals and sums values obtained by multiplying unique weight values to the respective signals.

In operation S105, that is, the controller 220 may generate the third value based on a weighted sum of the first value and the second value by inputting the first value and the second value into the single-layer perceptron model. The third value may be generated by multiplying the first value and the second value by the weight values and summing the multiplication results.

In operation S105, the controller 220 may obtain the third value, which is prediction data of the state of the battery. Herein, the third value may include lifetime data of the battery.

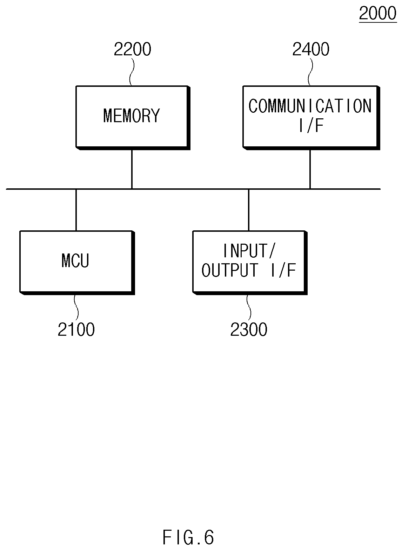

FIG. 6 is a block diagram showing a hardware configuration of a computing system for implementing a battery state prediction apparatus according to an embodiment disclosed herein.

Referring to FIG. 6, a computing system 2000 according to an embodiment disclosed herein may include an MCU 2100, a memory 2200, an input/output I/F 2300, and a communication I/F 2400.

The MCU 2100 may be a processor that executes various programs (e.g., a battery state prediction program, etc.) stored in the memory 2200, processes various data through these programs, and perform the above-described functions of the battery management apparatus 200 shown in FIG. 1.

The memory 2200 may store various programs regarding operations of the battery state prediction apparatus 200. Moreover, the memory 2200 may store operation data of the battery state prediction apparatus 200.

The memory 2200 may be provided in plural, depending on a need. The memory 2200 may be volatile memory or non-volatile memory. For the memory 2200 as the volatile memory, random access memory (RAM), dynamic RAM (DRAM), static RAM (SRAM), etc., may be used. For the memory 2200 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 2200 are merely examples and are not limited thereto.

The input/output I/F 2300 may provide an interface for transmitting and receiving data by connecting an input device (not shown) such as a keyboard, a mouse, a touch panel, etc., and an output device such as a display (not shown), etc., to the MCU 2100.

The communication I/F 2400, which is a component capable of transmitting and receiving various data to and from a server, may be various devices capable of supporting wired or wireless communication. For example, a program for resistance measurement and abnormality diagnosis of the battery cell or various data may be transmitted and received to and from a separately provided external server through the communication I/F 2400.

The above description is merely illustrative of the technical idea of the present disclosure, and various modifications and variations will be possible without departing from the essential characteristics of the present disclosure by those of ordinary skill in the art to which the present disclosure pertains.

Therefore, the embodiments disclosed in the present disclosure are intended for description rather than limitation of the technical spirit of the present disclosure and the scope of the technical spirit of the present disclosure is not limited by these embodiments. The protection scope of the present disclosure should be interpreted by the following claims, and all technical spirits within the same range should be understood to be included in the range of the present disclosure.

### [Description of Symbols]

1000: Battery Pack
100: Battery Module
200: Battery State Prediction Apparatus
210: Data Managing Unit
220: Controller
221: First Deep Learning Model
222: Second Deep Learning Model
300: Relay
A: Battery Data
A1: First Battery Data
A2: Second Battery Data
2000: Computing System
2100: MCU
2200: Memory
2300: Input/Output I/F
2400: Communication I/F

## Claims

1. A battery state prediction apparatus comprising:
a data managing unit configured to extract first battery data obtained for a predetermined time after completion of charging of a battery and second battery data obtained for the predetermined time after completion of discharging of the battery; and
a controller configured to obtain first state data for predicting a state of the battery by applying the first battery data to a first deep learning model, obtain second state data for predicting the state of the battery by applying the second battery data to a second deep learning model, and predict the state of the battery based on the first state data and the second state data.

2. The battery state prediction apparatus of claim 1, wherein the controller is further configured to generate third state data by combining the first state data with the second state data and predict the state of the battery based on the third state data.

3. The battery state prediction apparatus of claim 2, wherein the controller is further configured to extract a feature of the first battery data by applying the first battery data to a first convolutional neural network (CNN) model and extract a feature of the second battery data by applying the second battery data to a second CNN model.

4. The battery state prediction apparatus of claim 3, wherein the controller is further configured to generate a third value based on a weighted sum of a first value, obtained by converting the feature of the first battery data into an embedding vector, and a second value, obtained by converting the feature of the second battery data into an embedding vector, and predict the state of the battery based on the third value.

5. The battery state prediction apparatus of claim 1, wherein the first battery data and the second battery data comprise a voltage, a current, and a temperature of the battery, measured accumulatively, and the first state data, the second state data, and the third state data comprise a state of health (SoH) of the battery, calculated based on the first battery data and the second battery data.

6. An operating method of a battery state prediction apparatus, the operating method comprising:
extracting, from battery data, first battery data obtained for a predetermined time after completion of charging of a battery;
extracting, from the battery data, second battery data obtained for the predetermined time after completion of discharging of the battery;
obtaining first state data for predicting a state of the battery by applying the first battery data to a first deep learning model;
obtaining second state data for predicting the state of the battery by applying the second battery data to a second deep learning model; and
predicting the state of the battery based on the first state data and the second state data.

7. The operating method of claim 6, wherein the predicting of the state of the battery based on the first state data and the second state data comprises generating third state data by combining the first state data with the second state data and predicting the state of the battery based on the third state data.

8. The operating method of claim 7, wherein the obtaining of the first state data for predicting a state of the battery by applying the first battery data to the first deep learning model, comprises extracting a feature of the first battery data by applying the first battery data to a first convolutional neural network (CNN) model, and
the obtaining of the second state data for predicting the state of the battery by applying the second battery data to the second deep learning model, comprises extracting a feature of the second battery data by applying the second battery data to a second CNN model.

9. The operating method of claim 8, wherein the predicting of the state of the battery based on the first state data and the second state data comprises generating a third value based on a weighted sum of a first value, obtained by converting the feature of the first battery data into an embedding vector, and a second value, obtained by converting the feature of the second battery data into an embedding vector, and predicting the state of the battery based on the third value.

10. The operating method of claim 6, wherein the predicting of the state of the battery based on the first state data and the second state data comprises predicting a state of health (SoH) of the battery.
